(19)

Europäisches
Patentamt
European
Patent Office
Office européen
des brevets

(11) **EP 4 541 928 A1**

(12) **EUROPEAN PATENT APPLICATION**

(43) Date of publication:
**23.04.2025 Bulletin 2025/17**

(21) Application number: **23204984.1**

(22) Date of filing: **20.10.2023**

(51) International Patent Classification (IPC):
**C23C 14/54** *(2006.01)*        **C23C 14/30** *(2006.01)*
**C23C 14/50** *(2006.01)*

(52) Cooperative Patent Classification (CPC):
**C23C 14/541; C23C 14/30; C23C 14/50**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Sigmatech Ltd.
8000 Burgas (BG)**

(72) Inventors:
• **Tsepkalov, Andrii
 04108 Kyiv (UA)**
• **Zaitsev, Kostiantyn
 01033 Kyiv (UA)**
• **Fedotov, Dmytro
 02092 Kyiv (UA)**
• **Filippov, Oleksii
 Burgas (BG)**

(74) Representative: **Lapienis, Juozas
 MSP Europe UAB
 21-92 Seimyniskiu Str.
 09236 Vilnius (LT)**

(54) **REFLECTOR ASSEMBLY FOR HEATING PRODUCTS IN THE MANIPULATOR OF ELECTRON-BEAM COATERS**

(57)    The present invention relates to the field of heating products in the manipulator of electron-beam coaters, such as an apparatus for applying ceramic coatings on products, including turbine vanes of gas turbine engines, in particular, to a reflector assembly for performing said heating.

A reflector assembly has been developed for heating products in the manipulator of electron-beam coaters, in which the reflector is mounted above the thermal tray and above the coating zone, wherein the reflector is parabolic and is arranged to move along the vertical axis with a change in the size of the reflected heat spot on the product subjected to deposition.

Thus, a reflector assembly has been developed with the design ensuring the achievement of a technical result, which consists in the effective heating of the products fixed in the manipulator sockets, depending on their size, as well as in reducing the thermal effect on the manipulator itself.

**EP 4 541 928 A1**

## Description

The present invention relates to the field of heating products in the manipulator of electron-beam coaters, such as an apparatus for applying ceramic coatings on products, including turbine vanes of gas turbine engines, in particular, to a reflector assembly for performing said heating.

Electron Beam Physical Vapor Deposition (EB PVD) is a common method for applying protective ceramic coatings on various products, in particular turbine vanes of gas turbine engines. In the coating process, it is very important to maintain the desired temperature of the products subjected to deposition throughout the entire period of the coating process. For these purposes, procedures for direct heating of products with electron beam or procedures for indirect heating of products are used.

Direct heating of products with electron beam has a number of advantages, in particular, the ability to form the necessary heating zone using an appropriate electron beam scan; as well as high efficiency, as there is a direct heating of products with minimal impact on the surrounding elements. Though the procedure for direct heating has one significant drawback - the stability of maintaining the product temperature depends on the stable operation of electron-beam guns. For a number of reasons, arcing occurs in electron-beam guns, causing their short-term shutdown which leads to a stop in heating and a decrease in the product temperature. Such temperature fluctuations are unacceptable for obtaining a high-quality ceramic coating.

Indirect heating is devoid of this drawback, since the electron beam heats a massive intermediate body, and thus the product is heated therefrom. This eliminates product temperature drops during the arcing of electron-beam guns. However, the indirect heating also has a drawback - its low efficiency. So, most of the thermal energy is spent irrationally: passing by the products to be heated and heating the surrounding elements.

This drawback can be eliminated by placing the intermediary body and the product to be heated in a closed or partially closed volume, inside which thermal energy will be concentrated, which significantly increases the heating efficiency.

In patent document US2010/0047474 "Deposition apparatus having thermal hood", the coating zone is partially limited by a thermal shield "Thermohood" in the form of a half cylinder. This solution allows for significant increase in the efficiency of indirect heating and, at the same time, for achievement of a good temperature constancy of the products subjected to deposition. The shape of the semi-cylinder is in good alignment with the tumbler-shaped coating tool which rotates around its axis in the center of the semi-cylinder.

However, modern requirements for applying ceramic coatings to turbine vanes force the use of product manipulators that are more advanced than the tumbler. Modern manipulators have one or two arms, on which sockets are mounted for attaching products subjected to deposition. As a rule, these arms do not rotate around a common axis, but sway at a given angle, while the sockets with products rotate around their axes.

Basically, when working with such manipulators, the direct heating of products by a beam is used, though, as noted above, this method does not provide a guaranteed temperature profile for heating the product. The use of a "thermal hood" for heating products in such a manipulator turned out to be ineffective due to the fact that the size of the rotating parts together with the products subjected to deposition turned out to be very large, and, accordingly, a much larger shielded coating zone is required. Also, the rotation mechanisms of the manipulator arm sockets will be in the high-temperature zone together with the products subjected to deposition, which will lead to their overheating and early failure.

The closest to the present invention are US6770333 "Method of controlling temperature during coating deposition by EBPVD" and US 10385444 "Deposition apparatus and methods". In these patents, the use of movable reflectors in the form of plates or in another form is considered in order to reduce the heating of products as the process chamber becomes dusty, however, these reflectors are still characterized by insufficient product heating efficiency, as well as an adverse effect on the manipulator mechanism.

The problem to be solved by the invention is the creation of a reflector assembly, the design of which will ensure the achievement of a technical result, which consists in the effective heating of the products fixed in the manipulator sockets, depending on their size, as well as in reducing the thermal effect on the manipulator itself.

The problem in hand is solved by the fact that a reflector assembly has been developed for heating products in the manipulator of electron-beam coaters, in which the reflector is mounted above the thermal tray and above the coating zone, wherein the reflector is parabolic and is configured to move along the vertical axis with a change in the size of the reflected heat spot on the product subjected to deposition.

Thus, to ensure efficient heating of products in the manipulator, it is proposed to use a movable parabolic reflector. Although the parabolic reflector does not create a closed or partially closed volume, it allows more complete use of heat radiated by the intermediary body.

In a vacuum, thermal energy is transferred mainly by means of thermal-radiation. The advantage of a parabolic reflector over reflectors of another shape is that the parabolic reflector has a strictly defined focal length, at which all the radiation reflected from it is concentrated into a point. By varying the distance from the reflector to the products subjected to deposition, it is possible to change the size of the heating zone from a point to an area equal to the reflector, concentrating the reflected heat spot only on the products subjected to deposition and practically not affecting other elements of the coater.

Most preferably, the reflector of the inventive assembly is made in the form of a parabolic dish (when using only one crucible for evaporation) or in the form of a parabolic cylinder (when using two or more crucibles located along the axis of the manipulator, since the coating zone is extended along the line of crucibles proportionally to their number), the dimensions and focal length of which are determined by the dimensions of the coater process chamber and the general layout of the coating zone.

Also preferably, the reflector assembly comprises a system for focusing the reflected heat spot through a reflector height adjustment mechanism with a feedback from thermocouples located in the heating zone and in the unwanted heating zone, respectively.

The reflector can be made from any material capable of withstanding 1100°C while maintaining its shape. Preferably, the reflector is made of heat-resistant nickel alloys, ceramics or molybdenum and contains stiffeners to maintain a shape when heated.

In addition, the reflector assembly may include at least one protective removable shield mounted on the reflector from the side directed to the coater crucible.

The inventive assembly may comprise nozzles mounted on the reflector for supplying various gases towards the product subjected to deposition.

The invention is explained using the following drawings, where

Fig. 1 shows graphs of temperature versus time for direct and indirect heating, known from the prior art;

Fig. 2 shows a schematic view of an electron-beam coater according to US2010/0047474 described in the "prior art" section of this description;

Fig. 3 shows a general view of the thermal shield according to Fig. 2;

Fig. 4 shows a schematic view of the modern manipulator described in the "prior art" section of this description;

Fig. 5, 6 show a general view of reflectors according to the embodiments of the present invention;

Fig. 7 shows a schematic view of the reflector and heating zone with the dimensions shown;

Fig. 8A, 8B show a schematic view of a reflector according to an embodiment of the present invention and a heating zone with dimensions shown as the height of the reflector is changed;

Fig. 9 shows a schematic view of an electron-beam coater with a reflector assembly mounted according to an embodiment of the present invention.

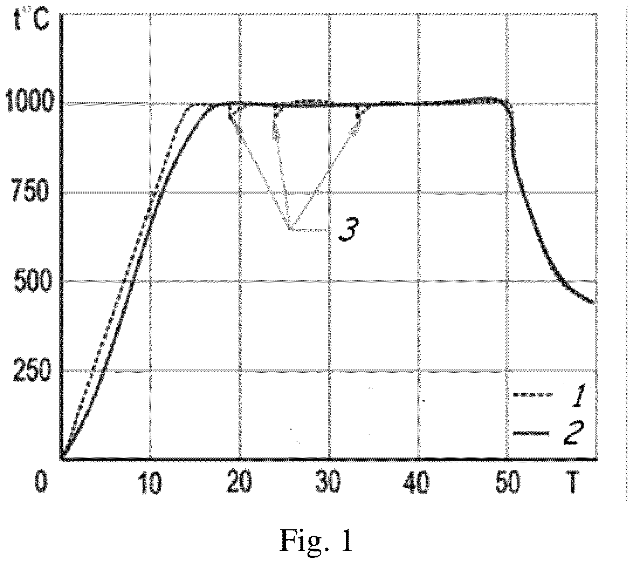

Fig. 1 shows graphs of temperature t in degrees Celsius (°C) versus time T in minutes, illustrating the prior art, where position 1 denotes a graph for direct heating by a beam; position 2 - a graph for indirect heating; position 3 - arcing of an electron-beam gun.

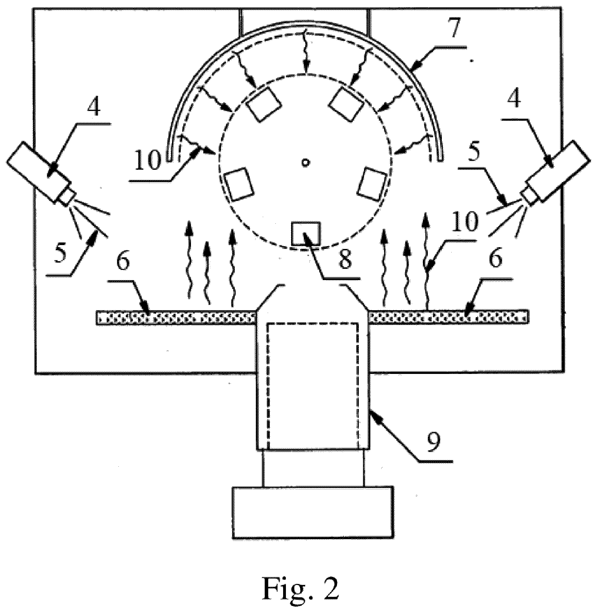

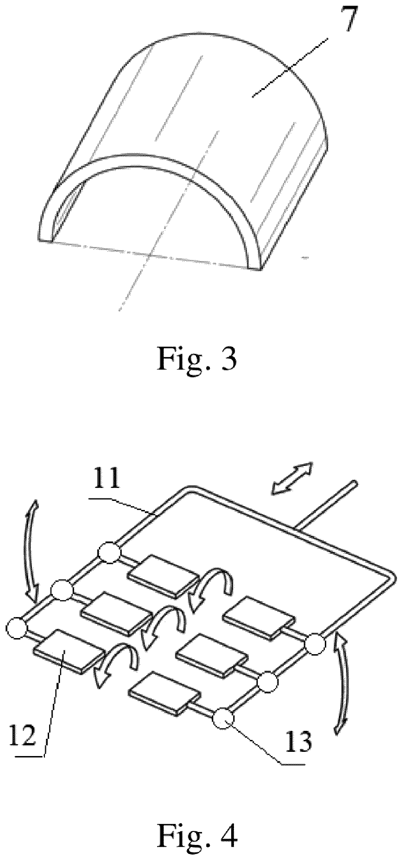

Fig. 2 shows a schematic view of an electron-beam coater according to the prior art of US2010/0047474, where said coater comprises electron-beam guns 4 emitting electron beams 5, an intermediary body 6 for indirect heating, a thermal shield 7 in the shape of a half-cylinder, a tool 8 with products subjected to deposition, a crucible 9. Position 10 denotes thermal radiation. Fig. 3 shows a general view of the thermal shield 7 in the form of a half-cylinder.

Fig. 4 shows a schematic view of the modern manipulator described in the "prior art" section. Said manipulator contains manipulator arms 11, sockets 12 with products subjected to deposition and rotation mechanisms 13 of the sockets.

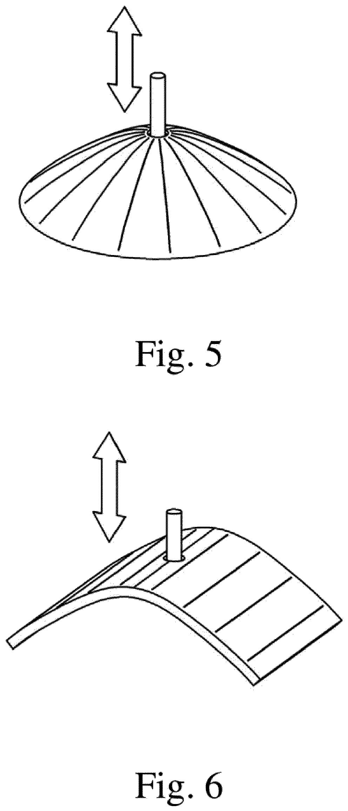

Fig. 5 shows a general view of an embodiment of the reflector in the form of a parabolic dish, Fig. 6 shows a general view of an embodiment of the reflector in the form of a parabolic cylinder. In said Figures, it can be seen that the reflectors are reinforced with stiffeners.

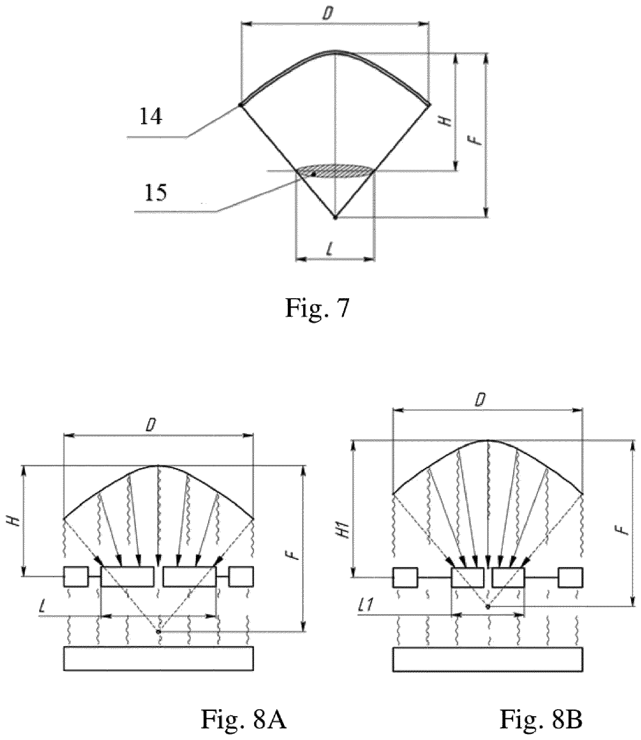

Fig. 7 shows a schematic view of the reflector 14 and the heating zone 15. For a given focal length F of the parabolic reflector 14, its size (diameter) D and the required size L of the heating zone, it is easy to determine the height H of the reflector 14 above the heating zone 15 by the formula:

$$H = F - L * F / D.$$

As mentioned above, this allows for concentration of the reflected heat spot only on the products subjected to deposition, almost without affecting other elements of the coater.

The mobility of the parabolic reflector 14 relative to the product subjected to deposition allows for adjusting the size of the thermal spot, selecting it according to the size of the product subjected to deposition. As can be seen in Fig. 8A and 8B, with the same focal length F of the reflector and its size D, an increase in the height H1 > H leads to a decrease in the heating zone L1 < L. Therefore, the parabolic reflector showed good efficiency of heating of the products in the manipulator.

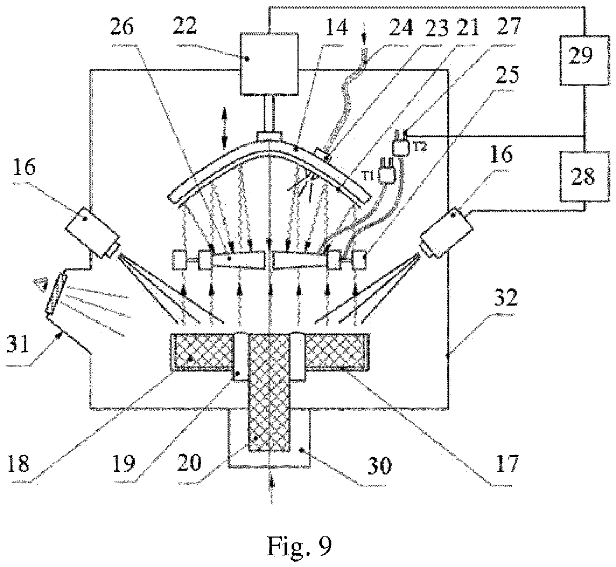

Fig. 9 shows a schematic view of an electron-beam coater with a reflector assembly 14 mounted. In said Figure also there are shown an electron-beam gun 16, a thermal tray 17; ceramic crumbs 18, a water-cooled crucible 19; a ceramic ingot 20, a protective replaceable shield 21, the reflector 14 height adjustment mechanism 22, a nozzle 23, a gas supply pipeline 24, a manipulator 25, a product 26, thermocouples 27, a system 28 for maintaining the product 26 temperature, a system 29 for focusing the reflected heat spot, an ingot feed mechanism 30, a viewing system 31, a vacuum process chamber 32.

Below is a more detailed description of the specified electron-beam coater.

The reflector assembly, comprising a reflector 14, a protective replaceable shield 21, a height adjustment mechanism 22 and a system 29 for focusing the reflected heat spot, operates as a part of the electron-beam coater, in particular, an apparatus for applying coatings used to apply ceramics on the product 26 by means of the electron-beam evaporation (EBPVD). Products 26 may be any parts, including turbine vanes of gas turbine engines, and ceramic coatings may be coatings of zirconium dioxide, gadolinium (III) oxide, and other ceramics.

The apparatus for applying coatings comprises:

a vacuum process chamber 32, which has water-cooled walls to withdraw excess heat during the coating process, and inside which all the elements of the apparatus are placed;

at least one heating source in the form of an electron-beam gun 16 used to heat and vaporize ceramics;

a thermal tray 17 filled with crumbs 18 of the same ceramic material, which is applied in the form of coatings on products (heating of ceramic crumbs in the thermal tray is carried out by means of scanning its surface with an electron beam);

at least one water-cooled crucible 19, through which a ceramic ingot 20 is fed for electron beam evaporation (wherein for the evaporation of the ingot, both the same electron-beam gun 16 as for heating the thermal tray and different electron beam-guns 16 can be used);

a manipulator 25, which may have one or two arms and, respectively, from one or more sockets for holders of the coating tool for products and is configured to perform translational and oscillatory movements along its longitudinal axis and rotational movements relative to the axes of the sockets for holders of the tool with products 26;

a parabolic reflector 14, suspended above the thermal tray 17 on the height adjustment mechanism 22 for adjusting its height over the products 26 subjected to deposition, wherein the working side of the reflector 14, facing the thermal tray and the crucible, is protected by a replaceable shield 21 for ease of cleaning after the end of the coating process;

a system 29 for focusing the reflected heat spot, which, through the reflector (8) height adjustment mechanism 22 sets the required size of the product 26 heating zone;

an ingot feed mechanism 30, serving for continuous feed of ceramic ingots 20 into the crucible 19;

at least one nozzle 23 with a pipeline 24, through which gas, such as oxygen, argon, helium, etc.is supplied to it to create a controlled atmosphere in the coating area;

thermocouples 27 mounted on the holders of the tool with products 26, the signal from which is fed to the system 28 for maintaining the product 26 temperature and to the reflector 14 height adjustment mechanism 22 control system, to control the temperature during the coating process;

a viewing system 31 for monitoring the coating process (a parabolic reflector does not block the view of the product subjected to deposition, unlike various semi-cylindrical shields and "hoods").

The claimed invention as a part of an electron-beam coater operates as follows.

Before starting the coating process, the type of product 26 subjected to deposition is selected and the reflector 14 is set to the working position for the selected type of product using the system 29 for focusing the reflected heat spot through the reflector height adjustment mechanism 22. Further, the product 26, placed in the sockets of the manipulator 25, is fed into the process chamber 32 into the coating zone. With the help of the electron-beam guns 16, the ceramic crumbs 18 are scanned with a beam in the thermal tray 17, causing their heating. As a result of heating, the ceramic crumbs 18 begin themselves emitting thermal radiation, which partially hits the product 26 being heated, and partially passes by and hits the parabolic reflector 14, reflected from which it returns to the product 26, ensuring its uniform heating.

By means of the system 29 for focusing the heat spot through the reflector 14 height adjustment mechanism 22, using feedback from thermocouples 27, in particular thermocouple T1 in the heating zone and thermocouple T2 in the zone where heating is undesirable (Fig. 9), the reflector 14 position is adjusted according to the maximum temperature difference. In this case, thermocouple T1 is located close to the boundary of the zone where heating is required, and thermocouple T2 is located close to the boundary of the zone where heating is undesirable.

By means of the system 28 for maintaining the product 26 temperature, using the feedback on the thermocouple T1 located in the heating zone, the beam current of the electron-beam guns 16 is regulated, providing the required heating rate and temperature of the product 26.

After the product 26 reaches the set temperature, the ceramic ingot 20 is vaporized from the crucible 19 using the electron-beam gun 16. The vapor flow from the crucible 19 is fed to the product 26 subjected to deposition, which rotates in the manipulator 25. Using the ingot feed mechanism 30, the ceramic ingot 20 is continuously fed into the crucible 19.

During the ceramics evaporation process, as necessary, process gas is supplied to the coating zone through the nozzles 23 mounted on the reflector 14 and directed to the product 26.

The coating process is carried out until the end of the evaporation of a certain amount of ceramic ingot 20, after which the process is completed. After the end of the coating process, using the manipulator 25, the product 26 is removed from the technological chamber 32 for its cooling.

The protective replaceable shield 21 is removed from the reflector 14 during cleaning of the process chamber 32 to remove ceramic condensate.

The parabolic reflector was tested in the process chamber of the SC-524 (PWP150/20) aircraft engine electron-beam coater for ceramics coating on Sigmatech aircraft engine vanes.

Process chamber dimensions: length 1400 mm, width 1200 mm, height 1200 mm. Manipulator dimensions: arm length 600 mm, distance between arms 500 mm, product heating zone between manipulator arms 300 mm.

Dimensions of parabolic cylinder reflector: length 700 mm, width 600 mm, focal length 800 mm. Distance from reflector to heating zone was adjustable within 300-500 mm. ~400 mm was chosen for the experiments. Two-shelf vanes PW4090-1V were subjected to deposition coating with zirconium dioxide, stabilized with yttrium. According to the results of the experiment, it was possible to reduce the heating time of the product from 20 to 16 minutes compared to using a shield in the form of a flat plate, at the same currents of electron-beam guns that carry out heating, wherein at a product temperature above 1000°C, the temperature of the sockets and the socket rotation mechanisms on the manipulator arms did not exceed 800°C.

Although the above is a specific design of an electron-beam coater comprising the inventive assembly, this design is not limiting the present invention and is given as an example to explain the latter.

Thus, a reflector assembly has been developed with the design ensuring the achievement of a technical result, which consists in the effective heating of the products fixed in the manipulator sockets, depending on their size, as well as in reducing the thermal effect on the manipulator itself.

## Claims

1. A reflector assembly for heating products in the manipulator of electron-beam coaters, in which the reflector is mounted above the thermal tray and above the coating zone, **characterized in that** the reflector is parabolic and is arranged to move along the vertical axis with a change in the size of the reflected heat spot on the product subjected to deposition.

2. The reflector assembly of claim 1, **characterized in that** the reflector is made in the form of a parabolic dish or in the form of a parabolic cylinder, the dimensions and focal length of which are determined by the dimensions of the coater process chamber.

3. The reflector assembly of claim 1, **characterized in that** it comprises a system for focusing the reflected heat spot through a reflector height adjustment mechanism with a feedback from thermocouples located in the heating zone and in the unwanted heating zone, respectively.

4. The reflector assembly of claim 1, **characterized in that** the reflector is made of heat-resistant nickel alloys, ceramics or molybdenum and contains stiffeners to maintain a shape when heated.

5. The reflector assembly of claim 1, **characterized in that** it comprises at least one protective removable shield mounted on the reflector from the side directed to the coater crucible.

6. The reflector assembly of claim 1, **characterized in that** it comprises nozzles mounted on the reflector for supplying various gases towards the product subjected to deposition.

Fig. 1

Fig. 2

Fig. 3

Fig. 4

Fig. 5

Fig. 6

Fig. 7

Fig. 8A

Fig. 8B

Fig. 9

**Europäisches Patentamt**
**European Patent Office**
**Office européen des brevets**

# EUROPEAN SEARCH REPORT

Application Number

EP 23 20 4984

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 770 333 B2 (GEN ELECTRIC [US]) 3 August 2004 (2004-08-03) | 1,2 | INV. C23C14/54 |
| A | * column 5, line 59 – column 6, line 30; claims; figure * | 3-6 | C23C14/30 C23C14/50 |

TECHNICAL FIELDS SEARCHED (IPC)

C23C

The present search report has been drawn up for all claims

| Place of search | Date of completion of the search | Examiner |
|---|---|---|
| The Hague | 19 February 2024 | Brothier, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 20 4984**

This annex lists the patent family members relating to the patent documents cited in the above-mentioned European search report.
The members are as contained in the European Patent Office EDP file on
The European Patent Office is in no way liable for these particulars which are merely given for the purpose of information.

**19-02-2024**

| Patent document cited in search report | Publication date | Patent family member(s) | Publication date |
|---|---|---|---|
| US 6770333 B2 | 03-08-2004 | NONE | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100047474 A
- US 6770333 B
- US 10385444 B